# FASCICULE DE BREVET EUROPEEN

(11) **EP 1 430 552 B1**
(45) Date de publication et mention de la délivrance du brevet: **15.10.2014**
(21) Numéro de dépôt: 02796325.5
(22) Date de dépôt: 29.08.2002
(51) Int. Cl.: H01L 51/00, H01L 51/05, H01L 49/02, G11C 13/02, G11C 13/00, B82Y 10/00

(54) **MEMOIRE MOLECULAIRE ET SON PROCEDE DE FABRICATION**
MOLEKULARSPEICHER UND VERFAHREN ZU SEINER HERSTELLUNG
MOLECULAR MEMORY AND METHOD FOR MAKING SAME

(30) Priorité: 31.08.2001 FR 0111328
(43) Date de publication de la demande: 23.06.2004
(73) Titulaire: CENTRE NATIONAL DE LA RECHERCHE SCIENTIFIQUE (CNRS), 75794 Paris Cedex 16 (FR)
(72) Inventeur: BOUSSEKSOU, Azzedine, F-31100 Toulouse (FR); VIEU, Christophe, F-31520 Ramonville-Saint-Agne (FR); LETARD, Jean-François Bât. I12G1, F-33608 Pessac (FR); DEMONT, Philippe, F-31500 Toulouse (FR); TUCHAGUES, Jean-Pierre, F-31520 Ramonville-Saint-Agne (FR); MALAQUIN, Laurent, F-12200 Villefranche-de-Rouergue (FR); MENEGOTTO, Jérôme, 31450 Donneville (FR); SALMON, Lionel, 11000 Carcassonne (FR)
(74) Mandataire: Novagraaf Technologies
(86) Numéro de dépôt international: PCT/FR2002/002961
(87) Numéro de publication internationale: WO 2003/019695

(56) Documents cités:
- EP-A- 0 666 561
- US-A- 5 582 900
- SMIT E ET AL: "The spin-transition complexes [Fe(Htrz)3](ClO4)2 and [Fe(NH2trz)3](ClO4)2 I. FT-IR spectra of a low pressure and a low temperature phase transition" MATERIALS RESEARCH BULLETIN, ELSEVIER SCIENCE PUBLISHING, NEW YORK, US, vol. 35, no. 10, 15 juillet 2000 (2000-07-15), pages 1697-1707, XP004226298 ISSN: 0025-5408
- PATENT ABSTRACTS OF JAPAN vol. 2000, no. 01, 31 janvier 2000 (2000-01-31) & JP 11 283880 A (MITSUBISHI CHEMICAL CORP), 15 octobre 1999 (1999-10-15)

## Description

La présente invention se rapporte au domaine de la micro-électronique, et notamment la fabrication d'un ensemble de condensateurs à taille nanométrique à mémoires moléculaires ou mémoires à base d'agrégats moléculaires

La présente invention se rapporte plus particulièrement à une mémoire moléculaire constituée d'un substrat, de préférence en silicium, d'un ensemble de condensateurs, chaque condensateur comportant deux couches conductrices constituant les armatures des condensateurs et entre lesquelles est disposée une matière diélectrique, ainsi que des moyens de connexion destinés à assurer les contacts électriques avec les circuits extérieurs.

Les mémoires actuellement utilisées sont des mémoires à semi-conducteurs, lesquelles utilisent les champs magnétique ou électrique pour écrire l'information. Elles présentent cependant une certaine instabilité, et a fortiori sont sensibles aux perturbations telles que le champ magnétique ou le champ électrique ambiants. D'autre part, la capacité mémoire reste encore relativement limitée du fait de la taille de ces mémoires.

La présente invention a donc pour but de remédier à ces inconvénients en proposant une mémoire constituée de condensateurs à taille nanométrique, afin de réaliser du stockage d'information à l'échelle moléculaire.

Pour se faire, la présente invention est du type décrit ci-dessus et elle est remarquable, dans son acception la plus large, en ce que la matière diélectrique est constituée au moins partiellement d'un complexe à transition de spin ou d'un matériau siège du phénomène de transition de spin.

La matière diélectrique est constituée au moins partiellement du composé [Fe(NH₂trz)₃] (NO₃)₂, du composé [Fe(Htrz)₂(trz)] (NO₃)₂ ou du composé [Fe (NH₂trz)₃] (Br)₂, ou est constituée au moins partiellement d'un alliage de ligands ou d'anions, choisi parmi le composé [Fe(Htrz)₃₋₃ₓ(NH₂trz)₃ₓ](ClO₄).H₂O ou le composé [Fe(NH₂trz)₃](NO₃)_{1.7}(BF₄)_{0.4}.

Selon un premier mode de réalisation de l'invention, la matière diélectrique est constituée du mélange du polymère contenant ces dérivés triazole avec un autre polymère dans de l'acétonitrile. Avantageusement, le mélange dans l'acétonitrile sera constitué de 40 % du polymère contenant des dérivés triazole et de 60 % de polyvinylacétate.

Selon un second mode de réalisation de l'invention, la matière diélectrique est constituée d'un mélange, soit du complexe à transition de spin avec un autre polymère dans le solvant du complexe à transition de spin, soit du matériau siège du phénomène de transition de spin avec un autre polymère dans le solvant du matériau.

De cette manière, l'enduction par « spin-coating » du complexe à transition de spin ou du matériau siège du phénomène de transition de spin, est facilitée.

Avantageusement, les armatures sont en or.

La présente invention porte également sur un procédé de fabrication d'une mémoire moléculaire selon l'invention, ledit procédé comportant successivement une étape de recouvrement dudit substrat (4) par ladite couche conductrice (9), une étape d'enduction de ladite matière diélectrique (1) sur ladite couche conductrice (9) et une étape de recouvrement de ladite matière diélectrique (1) par ladite couche conductrice (10), caractérisé en ce que ledit procédé comporte en outre les étapes suivantes :
a) imbibition par immersion d'un tampon dans une solution d'encrage d'HexaDécanéThiol;
b) séchage et lavage du tampon imbibé ;
c) réalisation d'une monocouche de protection sur l'une des couches conductrices par application du tampon imbibé, séché et lavé ;
d) réalisation d'une gravure chimique sur l'échantillon obtenu après l'étape c).

De préférence, la solution, laquelle présente une concentration molaire comprise entre 0,01 mol.L⁻¹ et 0,1 mol.L⁻¹, est portée à une température comprise entre 30°C et 50°C, afin de permettre la solubilisation des thiols contenus dans la solution d'encrage.

Avantageusement, la gravure chimique se déroule en milieu aqueux et à température ambiante, afin de ne pas détériorer le complexe et le polymère.

Avantageusement, le tampon est transparent, du type polydiméthylsiloxane.

Ce procédé de fabrication permet de mettre en forme la mémoire moléculaire sans altérer le complexe à transition de spin ou le matériau siège du phénomène de transition de spin constituant au moins partiellement la matière diélectrique (pas d'oxydation, pas de dissolution, ...). Ce procédé permet également d'aligner des motifs sur plusieurs niveaux pour la fabrication de composants mémoires complexes.

La présente invention porte également sur un procédé de mémorisation et de lecture d'information, réalisé à l'aide d'une mémoire moléculaire selon l'une quelconque des revendications 1 à 7, caractérisé en ce que la mémorisation et la lecture des informations sont basées sur les variations hystérétiques de la capacité et de la conductivité de ladite matière diélectrique (1).

On comprendra mieux l'invention à l'aide de la description, faite ci-après à titre purement explicatif, d'un mode de réalisation de l'invention, en référence aux figures annexées :
- la figure 1 illustre une vue en coupe d'un condensateur selon l'invention ;
- la figure 2 illustre les étapes du procédé de fabrication d'un ensemble de condensateurs selon l'invention ;
- la figure 3 illustre une vue en perspective d'un composant mémoire constitué d'un ensemble de condensateurs de tailles différentes, obtenu selon le procédé décrit figure 2.
- la figure 4 illustre un cycle d'hystérésis de la constante diélectrique mesurée dans un complexe à transition de spin.

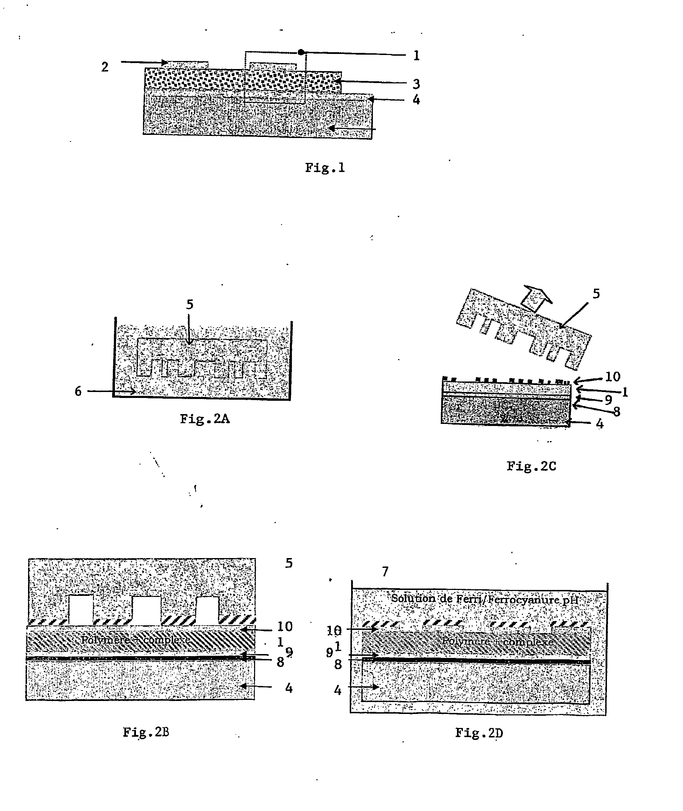

Le condensateur de taille nanométrique selon l'invention, illustré figure 1, est du type condensateur plan constitué de deux armatures conductrices (2, 3), l'armature dite inférieure (3) et l'armature dite supérieure (2), entre lesquelles est disposée une matière diélectrique (1). Ladite armature inférieure (3) dudit condensateur repose sur un substrat (4), de préférence en silicium.

Dans un mode de réalisation préféré, lesdites armatures (2, 3) sont en or.

Ladite matière diélectrique (1) est constituée au moins partiellement d'un polymère contenant des dérivés triazole choisi parmi les composés de la revendication 1. Ce complexe est mélangé à un polymère, du type polyvinylacétate, dans de l'acétonitrile, ceci afin de faciliter l'enduction par spin-coating dudit complexe.

Dans un mode de réalisation préféré, ladite matière diélectrique (1) est obtenue par le mélange dans l'acétonitrile de 40% dudit complexe avec 60% de polyvinylacétate.

Dans une première version de l'invention, ladite matière diélectrique est constituée du composé [Fe(NH₂trz)₃](NO₃)₂.

Dans une seconde version de l'invention, ladite matière diélectrique est constituée du composé [Fe(Htrz)₂(trz)](NO₃).

Dans une troisième version de l'invention, ladite matière diélectrique est constituée du composé [Fe(NH₂trz)₃](Br)₂.

Dans une dernière version de l'invention, ladite matière diélectrique est constituée d'un alliage de ligands ou d'anions choisi parmi les composés [Fe(Htrz)₃₋₃ₓ(NH₂trz)₃ₓ](ClO₄). H₂O ou [Fe(NH₂trz)₃](NO₃)_{1.7}(BF₄)_{0.4}.

Ladite matière diélectrique (1) peut être également constituée au moins partiellement d'un complexe à transition de spin, lequel sera mélangé dans le solvant de synthèse dudit complexe.

La figure 2 illustre les différentes étapes relatives à la fabrication d'une mémoire moléculaire constituée d'un ensemble de condensateurs selon l'invention.

Selon un mode de réalisation, ledit substrat (4) en silicium, présentant une épaisseur de 500 µm, est recouvert d'une couche d'adhérence en titane (8) d'une épaisseur de 50 nm, puis d'une couche d'or (9) d'une épaisseur de 50 nm, ladite couche d'or (9) représentant ladite armature inférieure (3). Ladite couche d'or (9) est ensuite enduite du mélange complexe/polymère constituant ladite matière diélectrique (1), le complexe étant soit un complexe moléculaire à transition de spin, soit un matériau siège du phénomène de transition de spin choisi parmi les composés de la revendication 1. Ladite matière diélectrique (1) est ensuite recouverte d'une couche d'or (10) d'une épaisseur de 50 nm. La fabrication desdites armatures supérieures (2) de chacun desdits condensateurs est alors conduite via une protection par micro/nano-tamponnage d'une solution d'encrage (6) composée de thiols dans l'éthanol absolu (HexaDécaneThiol).

Pour se faire, un tampon (5) en élastomère, élaboré à partir d'un moule initial fabriqué par les méthodes classiques de la micro-électronique (lithographique optique et gravure ionique ou lithographie électronique et gravure ionique pour des motifs micrométriques ou lithographie électronique et gravure ionique pour des motifs nanométriques), est imbibé par immersion dans ladite solution d'encrage (6) présentant une concentration de 0,1 mol.L⁻¹. Afin de permettre la solubilisation des thiols, ladite solution d'encrage (6) est portée à une température comprise entre 30°C et 50°C.

Après des opérations de séchage et de lavage de la surface dudit tampon (5) à l'éthanol absolu à une température de 60°C pour dissoudre les éventuels cristaux qui se sont formés après l'opération de séchage, ledit tampon (5) est appliqué sur ladite couche d'or (10). Ainsi, dans les zones de contact entre ledit tampon (5) et ladite couche d'or (10), sont déposées 0,1 mol.L-1 d'encre moléculaire, formant ainsi une couche moléculaire, pouvant être monomoléculaire, auto-assemblée, très dense. Par ce mécanisme, les motifs, initialement inscrits sur le moule, sont répliqués sur ladite couche d'or (10).

Ladite couche d'or (10) subit ensuite une gravure chimique afin de révéler les motifs formés par les monocouches de thiols. Pour se faire, les substrats précédemment obtenus sont plongés à température ambiante dans un milieu (7) aqueux, du type solution de Ferri/Ferrocyanure. La réaction se déroule à un pH 12 afin d'éviter tout risque de formation de HCN et d'empêcher la précipitation des silicates issus de la gravure chimique de la surface dudit substrat (4).

L'élastomère utilisé pour constituer ledit tampon (5) est le polydiméthylsiloxane, répondant également à l'appellation commerciale de Sylgard 184. Grâce à sa transparence, il rend possible l'alignement des motifs dudit tampon (5) sur des motifs préexistants sur l'échantillon. Cela permet ainsi la fabrication de dispositifs complexes nécessitant plusieurs niveaux de lithographie.

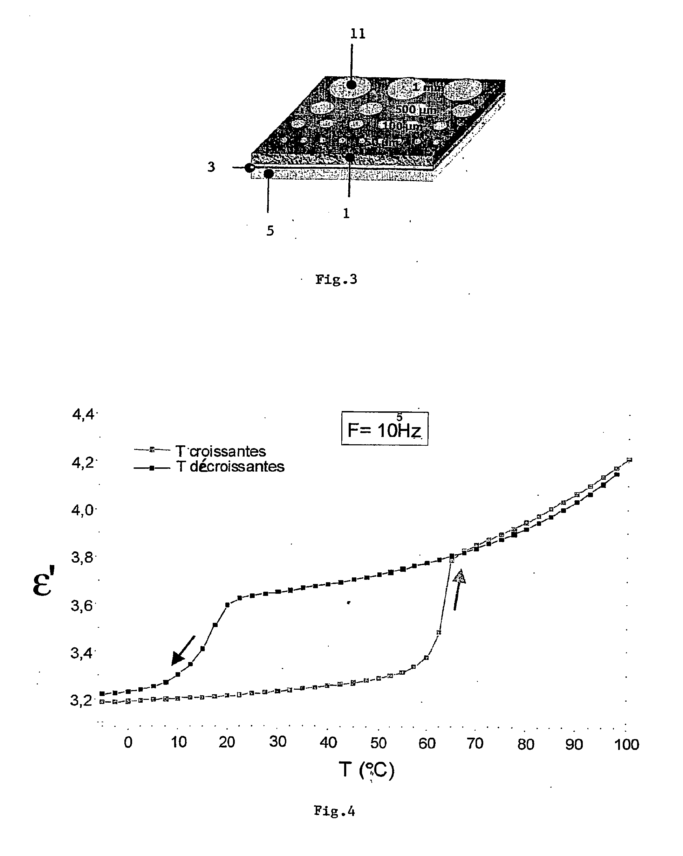

La figure 3 illustre un exemple de réalisation d'un composant mémoire constitué d'un ensemble de condensateurs de tailles différentes obtenu lors de la mise en oeuvre du procédé décrit ci-dessus. Ledit composant est constitué successivement d'un substrat (4), de préférence en silicium, d'une couche d'or (9) constituant ladite armature inférieure (3) desdits condensateurs, d'une matière diélectrique (1) constituée au moins partiellement d'un complexe moléculaire à transition de spin ou d'un matériau siège du phénomène de transition de spin choisi parmi les composés de la revendication 1, et de disques d'or (11) de différentes tailles, chacun constituant ladite armature supérieure (2) d'un condensateur. La face extérieure d'au moins une desdites armatures supérieures (2) est reliée par un fil de connexion à un plot de connexion placé sur une partie libre dudit substrat (4) afin d'assurer les contacts électriques avec les circuits extérieurs (non représenté sur la figure 3).

Le composant moléculaire peut être également constitué d'un ensemble de condensateurs planaires, chaque condensateur comportant deux armatures du type électrodes, de taille micrométrique ou nanométrique, entre lesquelles est disposée ladite matière diélectrique siège de transition de spin.

Les électrodes desdits condensateurs constituant un tel composant moléculaire sont fabriquées selon le procédé de tamponnage précédemment décrit ou par tout autre moyen de nanolithographie.

L'architecture horizontale de tels condensateurs présente ainsi de nombreux avantages, notamment en termes d'adressage et de densité d'intégration.

En outre, le stockage d'information et la lecture des informations peuvent être basés non seulement sur les variations hystérétiques de la capacité, mais également sur les variations hystérétiques de la conductivité du milieu électrique.

La figure 4 illustre à titre explicatif le comportement de la constante diélectrique mesurée dans le composé [Fe(NH₂trz)₃](NO₃)₂ en fonction de la température.

## Revendications

1. Mémoire moléculaire constituée d'un substrat (4), et d'un ensemble de condensateurs, chaque condensateur comportant deux couches conductrices (9, 10) constituant les armatures desdits condensateurs et entre lesquelles est disposée une matière diélectrique (1), ainsi que des moyens de connexion destinés à assurer les contacts électriques avec les circuits extérieurs, **caractérisée en ce que** l'ensemble de condensateurs est de taille nanométrique, et ladite matière diélectrique (1) présente une hystérésis de la constante diélectrique induite par la température et est constituée au moins partiellement d'un matériau siège du phénomène de transition de spin ou d'un complexe moléculaire à transition de spin choisi parmi les composés [Fe(NH₂trz)₃](NO₃)₂, [Fe(Htrz)₂(trz)](NO₃)₂, [Fe(NH₂trz)₂](Br)₃, [Fe(Htrz)₂₋₂ₓ(NH₂trz)₃ₓ](ClO₄).H₂O ou [Fe(NH₂trz)₃](NO₃)_{1.7}(BF₄)_{0.4}.

2. Mémoire moléculaire selon la revendication 1, dans laquelle ladite matière diélectrique (1) est constituée au moins partiellement d'un alliage de ligands ou d'anions choisi parmi les composés [Fe(Htrz)₃₋₃ₓ(NH₂trz)₃ₓ](ClO₄).H₂O ou [Fe (NH₂trz)₃](NO₃)_{1.7}(BF₄)_{0.4}.

3. Mémoire moléculaire selon l'une quelconque des revendications précédentes, dans laquelle ladite matière diélectrique (1) est constituée d'un mélange dudit complexe à transition de spin ou dudit matériau siège du phénomène de transition de spin avec un autre polymère.

4. Mémoire moléculaire selon la revendication 3, dans laquelle ledit mélange est constitué de 40% dudit complexe à transition de spin et 60% de polyvinylacétate dans de l'acétonitrile.

5. Mémoire moléculaire selon la revendication 3, dans laquelle ladite matière diélectrique (1) est constituée par le mélange dudit complexe à transition de spin avec ledit polymère dans le solvant dudit complexe à transition de spin, ou le mélange dudit matériau siège du phénomène de transition de spin avec ledit polymère dans le solvant dudit matériau.

6. Mémoire moléculaire selon la revendication 1, dans laquelle lesdites armatures sont en or.

7. Mémoire moléculaire selon l'une quelconque des revendications 1-6 dans laquelle ledit substrat est en silicium.

8. Procédé de fabrication d'une mémoire moléculaire selon l'une quelconque des revendications 1 à 7, ledit procédé comportant successivement une étape de recouvrement dudit substrat (4) par ladite couche conductrice (9), une étape d'enduction de ladite matière diélectrique (1) sur ladite couche conductrice (9) et une étape de recouvrement de ladite matière diélectrique (1) par ladite couche conductrice (10), **caractérisé en ce que** ledit procédé comporte en outre les étapes suivantes :
a) imbibition par immersion d'un tampon (5) dans une solution d'encrage (6) d'HexaDécaThiol ;
b) séchage et lavage dudit tampon (5) imbibé ;
c) réalisation d'une monocouche de protection sur ladite couche conductrice (10) par application dudit tampon (5) imbibé, séché et lavé ;
d) réalisation d'une gravure chimique sur l'échantillon obtenu après l'étape c).

9. Procédé de fabrication d'une mémoire moléculaire selon la revendication 8, **caractérisé en ce que** ladite solution d'encrage (6) présente une concentration molaire comprise entre 0,01 mol.L⁻¹ et 0,1 mol.L⁻¹.

10. Procédé de fabrication d'une mémoire moléculaire selon les revendications 8 ou 9, **caractérisé en ce que** ladite solution d'encrage (6) est portée à une température comprise entre 30°C et 50°C.

11. Procédé de fabrication d'une mémoire moléculaire selon la revendication 8, **caractérisé en ce que** la gravure chimique se déroule en milieu (7) aqueux et à température ambiante.

12. Procédé de fabrication d'une mémoire moléculaire selon la revendication 8, **caractérisé en ce que** ledit tampon (5) est transparent.

13. Procédé de fabrication d'une mémoire moléculaire selon la revendication 12, **caractérisé en ce que** ledit tampon (5) est le polydiméthylsiloxane.

14. Procédé de mémorisation et de lecture d'information, réalisé à l'aide d'une mémoire moléculaire selon l'une quelconque des revendications 1 à 7, **caractérisé en ce que** la mémorisation et la lecture des informations sont basées sur les variations hystérétiques de la capacité et de la conductivité de ladite matière diélectrique (1).

## Patentansprüche

1. Molekularspeicher bestehend aus einem Substrat (4), und einem Satz von Kondensatoren, wobei jeder Kondensator zwei leitende Schichten (9, 10) umfasst, welche die Armatur der Kondensatoren bilden und zwischen denen sich ein dielektrischer Stoff (1) befindet, sowie Anschlussmittel, um den elektrischen Kontakt mit externen Schaltkreisen zu gewährleisten, **dadurch gekennzeichnet, dass** der Kondensatorsatz nanometergross ist, und der dielektrische Stoff (1) eine Hysterese der dielektrischen Konstante aufweist, die durch die Temperatur induziert wird und zumindest teilweise aus einem Material besteht, das der Sitz des Phänomens des Spin-Übergangs oder eines Molekularkomplexes mit Spin-Übergang ist, ausgewählt aus den Verbindungen [Fe(NH₂trz)₃](NO₃)₂, [Fe(Htrz)₂(trz)](NO₃)₂, [Fe(NH₂trz)₃](Br)₂, [Fe(Htrz)₃₋₃ₓ(NH₂trz)₃ₓ](ClO₄).H₂O oder [Fe(NH₂trz)₃](NO₃)_{1.7}(BF₄)_{0.4}.

2. Molekularspeicher nach Anspruch 1, in dem der dielektrische Stoff (1) zumindest teilweise aus einer Liganden- oder Anionenlegierung besteht, ausgewählt aus den Verbindungen [Fe(Htrz)₃₋₃ₓ(NH₂trz)₃ₓ](ClO₄).H₂O oder [Fe(NH₂trz)₃](NO₃)_{1.7}(BF₄)_{0.4}.

3. Molekularspeicher nach einem beliebigen der voranstehenden Ansprüche, in dem der dielektrische Stoff (1) aus dem Komplex mit Spin-Übergang oder dem Material, das der Sitz des Phänomens des Spin-Übergangs ist, in Mischung mit einem anderen Polymer besteht.

4. Molekularspeicher nach Anspruch 3, in dem die Mischung zu 40% aus dem Komplex mit Spin-Übergang und zu 60% aus Polyvinylacetat in Acetonitril besteht.

5. Molekularspeicher nach Anspruch 3, in dem der dielektrische Stoff (1) aus der Mischung des Komplexes mit Spin-Übergang mit dem Polymer in dem Lösemittel des Komplexes mit Spin-Übergang, oder der Mischung des Materials, das der Sitz des Phänomens des Spin-Übergangs ist, mit dem Polymer in dem Lösemittel des Materials besteht.

6. Molekularspeicher nach Anspruch 1, in dem die Armatur aus Gold besteht.

7. Molekularspeicher nach einem der Ansprüche 1 bis 6, in dem das Substrat aus Silizium besteht.

8. Verfahren zur Herstellung eines Molekularspeichers nach einem der Ansprüche 1 bis 7, wobei das Verfahren aufeinanderfolgend einen Schritt des Abdeckens des Substrats (4) mit der leitenden Schicht (9), einen Schritt des Auftragens der dielektrischen Schicht (1) auf der leitenden Schicht (9) und einen Schritt des Abdeckens des dielektrischen Stoffs (1) mit der leitenden Schicht (10) umfasst, **dadurch gekennzeichnet, dass** das Verfahren ferner folgende Schritte umfasst:
a) Imbibieren eines Tupfers (5) durch Immersion in einer Färbelösung (6) aus Hexadecanethiol;
b) Trocknen und Waschen des durchtränkten Tupfers (5);
c) Ausführen einer einschichtigen Schutzschicht auf der leitenden Schicht (10) durch Aufdrücken des durchtränkten, getrockneten und gewaschenen Tupfers (5) ;
d) Ausführen einer chemischen Ätzung auf der nach Schritt c) erhaltenen Probe.

9. Verfahren zur Herstellung eines Molekularspeichers nach Anspruch 8, **dadurch gekennzeichnet, dass** die Färbelösung (6) eine molare Konzentration zwischen 0,01 mol.L⁻¹ und 0,1 mol.L⁻¹ aufweist.

10. Verfahren zur Herstellung eines Molekularspeichers nach einem der Ansprüche 8 oder 9, **dadurch gekennzeichnet, dass** die Färbelösung (6) auf eine Temperatur zwischen 30 °C und 50 °C gebracht wird.

11. Verfahren zur Herstellung eines Molekularspeichers nach Anspruch 8, **dadurch gekennzeichnet, dass** die chemische Ätzung in einem wässrigen Medium (7) bei Raumtemperatur stattfindet.

12. Verfahren zur Herstellung eines Molekularspeichers nach Anspruch 8, **dadurch gekennzeichnet, dass** der Tupfer (5) transparent ist.

13. Verfahren zur Herstellung eines Molekularspeichers nach Anspruch 12, **dadurch gekennzeichnet, dass** der Tupfer (5) aus Polydimethylsiloxan besteht.

14. Verfahren zum Speichern und Lesen von Information mit Hilfe eines Molekularspeichers nach einem der Ansprüche 1 bis 7, **dadurch gekennzeichnet, dass** die Speicherung und das Lesen der Informationen auf hysteretischen Veränderungen der Kapazität und der Leitfähigkeit des dielektrischen Stoffes (1) beruhen.

## Claims

1. Molecular memory constituted by a substrate (4), and a set of condensers, each condenser comprising two conductive layers (9, 10) constituting the armatures of said condensers and between which is placed a dielectric material (1), as well as connecting means intended to ensure the electric contacts with external circuits, **characterized in that** the set of condensers is of nanometric proportions, and **in that** said dielectric material (1) shows hysteresis of the temperature-induced dielectric constant, and is at least partially constituted by a support material of the spin transition phenomenon or of a spin transition molecular complex chosen from the compounds [Fe (NH₂trz)₃](NO₃)₂, [Fe(Htrz)₂(trz)](NO₃)₂, [Fe(NH₂trz)₃](Br)₂, [Fe(Htrz)₃-₃ₓ(NH₂trz)₃ₓ](ClO₄).H₂O, or [Fe(NH₂trz)₃](NO₃)_{1.7}(BF₄)_{0.4}.

2. Molecular memory according to claim 1, wherein said dielectric material (1) is constituted at least partially by an alloy of ligands or anions chosen from compounds [Fe(Htrz)₃₋₃ₓ(NH₂trz)₃ₓ](ClO₄).H₂O, or [Fe(NH₂trz)₃](NO₃)_{1.7}(BF₄)0.4.

3. Molecular memory according to any one of the preceding claims, wherein said dielectric material (1) is constituted by a mixture of said spin transition complex or said support material of the spin transition phenomenon with another polymer.

4. Molecular memory according to claim 3, wherein said mixture is constituted by 40% of said spin transition complex and 60% of polyvinyl acetate in acetonitrile.

5. Molecular memory according to claim 3, wherein said dielectric material (1) is constituted by the mixture of said spin transition complex with said polymer in the solvent of said spin transition complex, or the mixture of said support material of the spin transition phenomenon with said polymer in the solvent of said material.

6. Molecular memory according to claim 1, wherein said armatures are made of gold.

7. Molecular memory according to one of claims 1-6 wherein said substrate is made of silicon.

8. Method of manufacturing a molecular memory according to any one of claims 1 to 7, said method comprising successively a step of covering said substrate (4) with said conductive layer (9), a step of coating said dielectric material (1) on said conductive layer (9) and a step of covering said dielectric material (1) with said conductive layer (10), **characterized in that** said method further comprises the following steps:
a) impregnation by immersion of a buffer (5), in an inking solution (6) of hexadecanethiol;
b) drying and washing said impregnated buffer (5);
c) formation of a protective monolayer on said conductive layer (10) by application of said impregnated, dried and washed buffer (5);
d) formation of a chemical etching on the sample obtained after step c).

9. Method of manufacturing a molecular memory according to claim 8, **characterized in that** said inking solution (6) has a molar concentration comprised between 0.01 mol·L⁻¹ and 0.1 mol·L⁻¹.

10. Method of manufacturing a molecular memory according to claim 8 or 9, **characterized in that** said inking solution (6) is brought to a temperature comprised between 30° C and 50°C.

11. Method of manufacturing a molecular memory according to claim 8, **characterized in that** said chemical etching takes place in an aqueous medium (7) at ambient temperature.

12. Method of manufacturing a molecular memory according to claim 8, **characterized in that** said buffer (5) is transparent.

13. Method of manufacturing a molecular memory according to claim 8, **characterized in that** said buffer (5) is polydimethylsiloxane.

14. Method of storing in a memory and of reading information, carried out by means of a molecular memory according to any one of claims 1 to 7, **characterized in that** the storing in a memory and the reading of information are based on hysteretic variations of the capacity and of the conductivity of said dielectric material (1).
